# EUROPEAN PATENT APPLICATION

(11) **EP 4 716 414 A1**
(43) Date of publication of application: **25.03.2026**
(21) Application number: 25817396.2
(22) Date of filing: 16.04.2025
(51) Int. Cl.: H10F 10/14, H10F 77/30

(54) **SOLAR CELL, SOLAR MODULE, AND PHOTOVOLTAIC SYSTEM**

(30) Priority: 24.07.2024 CN 202411000880
(71) Applicant: Zhuhai Fushan Aiko Solar Energy Technology Co., Ltd., Zhuhai, Guangdong 519000 (CN); Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: MEI, Fei, Zhejiang 322000 (CN); CHEN, Gang, Zhejiang 322000 (CN)
(74) Representative: EP&C
(86) International application number: PCT/CN2025/089385
(87) International publication number: WO 2026/020897

(57) **Abstract**

The present disclosure is applicable to the technical field of solar cells, and provides a solar cell, a cell assembly, and a photovoltaic system. In the solar cell, P-type doped layers and N-type doped layers are disposed on a first surface of a silicon wafer, and a thickness of a passivation film layer on at least some regions of the N-type doped layers is greater than a thickness of at least some regions of the passivation film layer on the P-type doped layers. In this way, by performing cooperative optimization design of different thicknesses on the passivation film layer on at least some regions of the N-type doped layers and at least some regions of the P-type doped layers, and setting the thickness of the passivation film layer on at least some regions of the N-type doped layers to be greater, the passivation effects of different doped regions of the solar cell can achieve a better matching effect, thereby improving the performance of the solar cell, and meanwhile saving material use and reducing the cost.

## Description

### Cross-Reference to Related Application

The present disclosure claims the priority of Chinese Patent Application 202411000880. 2, filed in the China National Intellectual Property Administration on July 24, 2024, and entitled "Solar Cell, Cell Assembly and Photovoltaic System", the entire contents of which are herein incorporated by reference.

### Technical Field

The present disclosure relates to the technical field of solar cells, and particularly relates to a solar cell, a cell assembly, and a photovoltaic system.

### Background

Solar cell power generation is a sustainable and clean energy source that utilizes the photovoltaic effect of semiconductor p-n junctions to convert sunlight into electrical energy. In a solar cell, a P-type doped layer and an N-type doped layer are disposed on a silicon wafer, and passivation film layer are disposed on the doped layers to passivate the cell.

In the current solar cells, the mutual cooperative optimization between the passivation film layer on the P-type doped layer and the N-type doped layer has not been fully considered to improve the passivation effect, resulting in poor performance of the current solar cells.

### Summary

The present disclosure provides a solar cell, a cell assembly, and a photovoltaic system.

The present disclosure is implemented in such a manner that the solar cell in the embodiments of the present disclosure includes:
a silicon wafer, having a first surface and a second surface opposite to each other;
P-type doped layers and N-type doped layers, disposed on the first surface of the silicon wafer; and
a passivation film layer, disposed on the P-type doped layers and the N-type doped layers, where the passivation film layer on at least some regions of the N-type doped layers have a first thickness, the passivation film layer on at least some regions of the P-type doped layers have a second thickness, and the first thickness is greater than the second thickness.

In some embodiments, the first surface has an edge region and an intermediate region, the intermediate region is located on an inner side of the edge region, and the edge region is closer to an edge of the first surface than the intermediate region; and
a portion of at least one N-type doped layer located on the intermediate region is a first N-type doped portion, the passivation film layer located on the first N-type doped portion has the first thickness, a portion of at least one P-type doped layer located on the intermediate region is a first P-type doped portion, and the passivation film layer located on the first P-type doped portion has the second thickness.

In some embodiments, a portion of at least one N-type doped layer located on the edge region is a second N-type doped portion, the passivation film layer located on the second N-type doped portion has a third thickness, a portion of at least one P-type doped layer located on the edge region is a second P-type doped portion, the passivation film layer located on the second P-type doped portion has a fourth thickness, the third thickness is greater than the first thickness, and the fourth thickness is greater than the second thickness.

In some embodiments, the third thickness is greater than the fourth thickness.

In some embodiments, the passivation film layer covering the intermediate region is of an integrated continuous structure.

In some embodiments, a ratio of the first thickness to the second thickness is greater than 1 and less than or equal to 2.

In some embodiments, the ratio of the first thickness to the second thickness is 1.025 to 1.6.

In some embodiments, a difference value between the first thickness and the second thickness is 2 nm to 50 nm.

In some embodiments, the difference value between the first thickness and the second thickness is 5 nm to 30 nm.

In some embodiments, the first thickness is 52 nm to 250 nm, and the second thickness is 50 nm to 200 nm.

In some embodiments, the first thickness is 55 nm to 230 nm, and the second thickness is 50 nm to 200 nm.

In some embodiments, on the intermediate region, there is a spacer region between one P-type doped layer and one N-type doped layer adjacent to each other, the passivation film layer further covers the spacer region, a portion of the passivation film layer located on the spacer region has a fifth thickness, and the second thickness is greater than the fifth thickness.

In some embodiments, on the intermediate region, the passivation film layer on the P-type doped layers, the passivation film layer on the N-type doped layers, and the passivation film layer on spacer regions is an integrated continuous structure.

In some embodiments, a ratio of the second thickness to the third thickness is greater than 1 and less than or equal to 2.

In some embodiments, the ratio of the second thickness to the third thickness is 1.1 to 1.8.

In some embodiments, a difference value between the second thickness and the third thickness is 2 nm to 50 nm.

In some embodiments, the difference value between the second thickness and the third thickness is 20 nm to 40 nm.

In some embodiments, the second thickness is 50 nm to 200 nm, and the third thickness is 48 nm to 150 nm.

In some embodiments, the second thickness is 50 nm to 200 nm, and the third thickness is 30 nm to 160 nm.

In some embodiments, a resistivity of the silicon wafer is greater than 20 ohm.cm, and a difference value between the second thickness and the fifth thickness is 10 nm to 60 nm.

In some embodiments, the spacer region is a groove formed on the first surface, the passivation film layer covers a side surface and a bottom surface of the groove, a thickness of at least some regions of the passivation film layer located on the side surface of the groove is greater than a thickness of the passivation film layer located on the bottom surface of the groove.

In some embodiments, the solar cell further satisfies at least one of the following:
the N-type doped layer is provided with a first extension portion extending to an upper side of the groove and suspending above the groove, and an end portion of the first extension portion and a surface of the first extension portion facing the groove are both provided with the passivation film layer, where a thickness of the passivation film layer located on the surface of the first extension portion facing the groove is greater than the thickness of the passivation film layer located on the bottom surface of the groove; and
the P-type doped layer is provided with a second extension portion extending to the upper side of the groove and suspending above the groove, and an end portion of the second extension portion and a surface of the second extension portion facing the groove are both provided with the passivation film layer, where a thickness of the passivation film layer located on the surface of the second extension portion facing the groove is greater than the thickness of the passivation film layer located on the bottom surface of the groove.

In some embodiments, the spacer region is a boss located between the P-type doped layer and the N-type doped layer adjacent to each other, a top surface of the boss is higher than a top of the P-type doped layer and a top of the N-type doped layer, the top surface and a side surface of the boss are both provided with the passivation film layer, and a thickness of the passivation film layer located on the top surface of the boss is greater than a thickness of the passivation film layer located on the side surface of the boss.

In some embodiments, a portion of the passivation film layer located in the intermediate region includes at least one first-type passivation sub-layer and at least one second-type passivation sub-layer that are stacked, and a thickness of the passivation film layer located in the intermediate region is a sum of a thickness of the first-type passivation sub-layer and the thickness of the second-type passivation sub-layer; and
a thickness of a portion of the first-type passivation sub-layer located on the N-type doped layer is greater than a thickness of a portion of the first-type passivation sub-layer located on the P-type doped layer.

In some embodiments, a thickness of a portion of the second-type passivation sub-layer located on the N-type doped layer is equal to a thickness of a portion of the second-type passivation sub-layer located on the P-type doped layer.

In some embodiments, the first-type passivation sub-layer is manufactured by a Plasma Enhanced Chemical Vapor Deposition (PECVD) process or a thermal growth process, and the second-type passivation sub-layer is manufactured by an atomic deposition process.

In some embodiments, the first-type passivation sub-layer includes at least one of a silicon oxide film layer and a silicon nitride film layer, and the second-type passivation sub-layer includes an aluminum oxide film layer.

In some embodiments, the silicon oxide film layer is a plurality of layers of silicon oxide stacked in sequence, the silicon nitride film layer is a plurality of layers of silicon nitride stacked in sequence, and a silicon oxynitride film layer is a plurality of layers of silicon oxynitride stacked in sequence.

The present disclosure further provides a cell assembly, including several solar cells mentioned above.

The present disclosure further provides a photovoltaic system, including the above cell assembly.

In the solar cell, the cell assembly and the photovoltaic system in the embodiments of the present disclosure, the P-type doped layers and the N-type doped layers are disposed on the first surface of the silicon wafer, and the thickness of the passivation film layer on at least some regions of the N-type doped layers is greater than the thickness of at least some regions of the passivation film layer on the P-type doped layers. In this way, by performing cooperative optimization design of different thicknesses on the passivation film layer on at least some regions of the N-type doped layers and at least some regions of the P-type doped layers, and setting the thickness of the passivation film layer on at least some regions of the N-type doped layers to be greater, the passivation effects of different doped regions of the solar cell can achieve a better matching effect, thereby improving the performance of the solar cell, and meanwhile saving material use and reducing the cost.

Additional aspects and advantages of the present disclosure will be given in part in the following description, become apparent in part from the following description, or be learned from the practice of the present disclosure.

### Brief Description of the Drawings

Fig. 1 is a schematic diagram of modules of a photovoltaic system provided in an embodiment of the present disclosure;
Fig. 2 is a schematic diagram of a cross-sectional structure of a solar cell provided in an embodiment of the present disclosure;
Fig. 3 is a schematic diagram of a planar structure of a partial structure of a solar cell provided in an embodiment of the present disclosure;
Fig. 4 is a schematic diagram of a cross-sectional structure of a solar cell provided in an embodiment of the present disclosure in an intermediate region;
Fig. 5 is a schematic structural diagram of a passivation film layer provided in an embodiment of the present disclosure in an intermediate region;
Fig. 6 is a schematic diagram of another cross-sectional structure of a solar cell provided in an embodiment of the present disclosure in the intermediate region;
Fig. 7 is a schematic diagram of yet another cross-sectional structure of a solar cell provided in an embodiment of the present disclosure in the intermediate region;
Fig. 8 is a schematic diagram of still another cross-sectional structure of a solar cell provided in an embodiment of the present disclosure in the intermediate region; and
Fig. 9 is a schematic diagram of still another cross-sectional structure of a solar cell provided in an embodiment of the present disclosure in the intermediate region.

### Detailed Description of the Embodiments

In order to make the objectives, technical solutions and advantages of the present disclosure clearer, the present disclosure will be further described in detail below in combination with the drawings and embodiments. Examples of the embodiments are shown in the drawings, where the same or similar reference signs represent the same or similar elements or elements with the same or similar functions throughout. It should be noted that the embodiments described below with reference to the drawings are exemplary and are merely used to explain the present disclosure, and cannot be construed as limiting the present disclosure. In addition, it should be understood that the specific embodiments described herein are only used to explain the present disclosure and are not intended to limit the present disclosure.

In the description of the present disclosure, it should be understood that orientation or position relationships indicated by terms "upper", "lower", "left", "right", "top", "bottom", "side surface" and the like are orientation or position relationships shown on the basis of the drawings, and are merely for the convenience of describing the present disclosure and simplifying the description, but do not indicate or imply that referred apparatuses or elements must have specific orientations or must be constructed and operated in specific orientations, and thus cannot be construed as limitations to the present disclosure.

In addition, the terms "first", "second" and the like are used for descriptive purposes only and cannot be understood as indicating or implying relative importance or implicitly indicating the number of indicated technical features. Therefore, features defined with "first" and "second" may explicitly or implicitly include one or more of the features. In the description of the present disclosure, "several" means two or more, unless specifically defined otherwise.

In the present disclosure, unless otherwise specified and limited, a first feature being "on" or "under" a second feature may include that the first feature is in direct contact with the second feature, or the first feature is not in contact with the second feature but is in contact with the second feature through an additional feature therebetween. Moreover, the first feature being "over", "above" and "on" the second feature includes that the first feature is directly above and obliquely above the second feature, or merely indicates that a horizontal height of the first feature is greater than that of the second feature. The first feature being "under", "below" and "beneath" the second feature includes that the first feature is directly below and obliquely below the second feature, or merely indicates that the horizontal height of the first feature is less than that of the second feature.

The following disclosure provides many different embodiments or examples to implement different structures of the present disclosure. In order to simplify the disclosure of the present disclosure, components and settings of specific examples are described below. Of course, they are merely examples, and are not intended to limit the present disclosure. In addition, the present disclosure may repeat reference numerals and/or reference letters in different examples, and this repetition is for the purpose of simplicity and clarity, and does not indicate the relationship between various embodiments and/or settings discussed. In addition, the present disclosure provides examples of various specific processes and materials, but those ordinary skilled in the art may be aware of applications of other processes and/or usage scenarios of other materials.

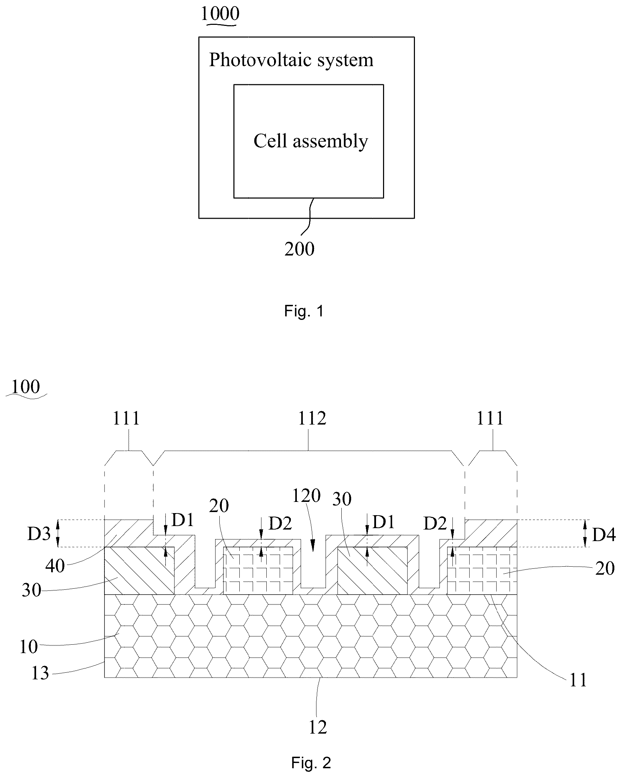

Referring to Fig. 1, a photovoltaic system 1000 in the embodiments of the present disclosure may include a cell assembly 200 in the embodiments of the present disclosure, the cell assembly 200 in the embodiments of the present disclosure may include several solar cells 100 in the embodiments of the present disclosure, the several solar cells 100 may be connected in series by means of a solder strip to form several battery strings, and the battery strings may form the cell assembly 200 in a series, parallel, or series-parallel manner.

Referring to Fig. 2, the solar cell 100 in the embodiments of the present disclosure may include a silicon wafer 10, P-type doped layers 20, N-type doped layers 30 and a passivation film layer 40.

The silicon wafer 10 has a first surface 11 and a second surface 12 opposite to each other, and the P-type doped layers 20 and the N-type doped layers 30 are disposed on the first surface 11 of the silicon wafer 10. The passivation film layer 40 cover the first surface 11, and the P-type doped layers 20 and the N-type doped layers 30 are covered with the passivation film layer 40.

As shown in Fig. 2, the passivation film layer 40 on at least some regions of the N-type doped layers 30 have a first thickness D1, the passivation film layer 40 on at least some regions of the P-type doped layers 20 have a second thickness D2, and the first thickness D1 is greater than the second thickness D2.

In the solar cell 100, the cell assembly 200 and the photovoltaic system 1000 in the embodiments of the present disclosure, the P-type doped layers 20 and the N-type doped layers 30 are disposed on the first surface 11 of the silicon wafer 10, and the thickness of the passivation film layer 40 on at least some regions of the N-type doped layers 30 is greater than the thickness of at least some regions of the passivation film layer 40 on the P-type doped layers 20, that is, the first thickness D1 is greater than the second thickness D2. In this way, by means of performing cooperative optimization design of different thicknesses on the passivation film layer 40 on at least some regions of the N-type doped layers 30 and at least some regions of the P-type doped layers 20, and setting the thickness of the passivation film layer 40 on at least some regions of the N-type doped layers 30 to be greater, the passivation effects of different doped regions of the solar cell 100 can achieve a better matching effect, thereby improving the performance of the solar cell 100, and meanwhile saving material use and reducing the cost.

Specifically, in the embodiments of the present disclosure, the first surface 11 may be a back surface of the silicon wafer 10, and the second surface 12 may be a front surface of the silicon wafer 10. The solar cell 100 is preferably a back-contact solar cell. Of course, in some embodiments, the solar cell 100 may also be another type of cell having the P-type doped layers 20 and the N-type doped layers 30 on the same surface, which is not specifically limited herein.

The silicon wafer 10 may be a P-type silicon wafer or an N-type silicon wafer, which is not specifically limited herein, the P-type doped layer 20 may be a P-type doped polysilicon layer, a P-type doped microcrystalline silicon layer, and the like, the N-type doped layer 30 may be an N-type doped polysilicon layer, an N-type doped microcrystalline silicon layer, and the like, and the P-type doped layer 20 and the N-type doped layer 30 may be manufactured by diffusion, deposition and other manners, which is not specifically limited herein.

It should be noted that in the present disclosure, the thickness of the passivation film layer 40 on the N-type doped layer 30 refers to the thickness of the passivation film layer 40 on all surfaces of the N-type doped layer 30 that covered with the passivation film layer 40, and similarly, the thickness of the passivation film layer 40 on the P-type doped layer 20 refers to the thickness of the passivation film layer 40 on all surfaces of the P-type doped layer 20 that are covered with the passivation film layer 40.

In addition, herein, a certain film layer covers a certain surface or a certain film layer may be that the film layer is directly stacked on the certain surface or the certain film layer, or another film layer may be further disposed between the film layer and the surface or the film layer, and the coverage is merely used to limit a specific setting range of the film layer.

It can be understood that in the back-contact solar cell, the first surface 11 is provided with several P-type doped layers 20 and several N-type doped layers 30, and the several P-type doped layers 20 and the several N-type doped layers 30 are alternately arranged in sequence. In addition, it is not difficult to understand that in the back-contact solar cell, tunneling layers (not shown in the Figs) may also be generally disposed among the P-type doped layers 20, the N-type doped layers 30 and the silicon wafer 10.

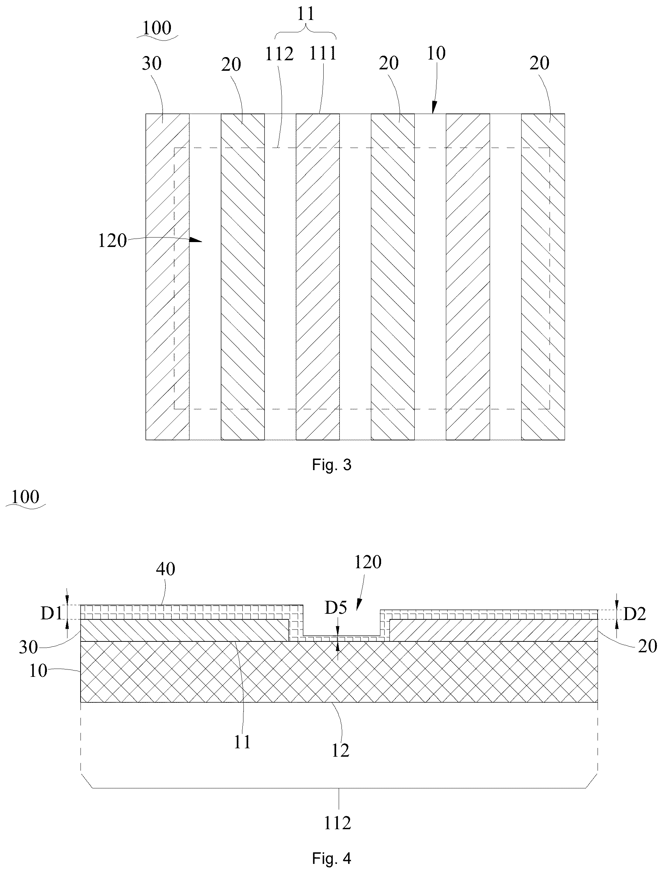

Referring to Fig. 2 and Fig. 4, in some embodiments, the first surface 11 has an edge region 111 and an intermediate region 112, the intermediate region 111 is located on an inner side of the edge region 112, and the edge region 111 is closer to an edge of the first surface 11 than the intermediate region 112.

The passivation film layer 40 on the portion of the N-type doped layer 30 located on the intermediate region 112 has the first thickness D1, and the passivation film layer 40 on the portion of the P-type doped layer 20 located on the intermediate region 112 has the second thickness D2.

In this way, the passivation effects of the regions corresponding to the N-type doped layer 30 and the P-type doped layer 20 at the intermediate region 112 may have a better effect, thereby improving the performance of the solar cell 100.

Specifically, as shown in Fig. 2, in such an embodiment, the silicon wafer 10 further includes several side surfaces 13 for connecting the first surface 11 and the second surface 12, the edge region 111 is located at a boundary edge position between the first surface 11 and the side surface 13, the intermediate region 112 is located at an intermediate position of the first surface 11, and the edge region 111 is located between the intermediate region 112 and the side surface 13.

As shown in Fig. 2, the "edge region 111" refers to a region located near an edge of a boundary between the first surface 11 and the side surface 13, and the "intermediate region 112" refers to a region other than the edge region 111 in the first surface 11.

As shown in Fig. 3 (the passivation film layer 40 is not shown in Fig. 3), in some embodiments, a specific setting manner of the intermediate region 112 and the edge region 111 may be as shown in Fig. 3, in such an embodiment, the edge region 111 may be disposed around the intermediate region, that is, the boundaries between the edge of the first surface 11 and all the side surfaces 13 are provided with the edge region 111, and the intermediate region 112 is located in the edge region 110, that is, the edge region 11 is a region located at each edge position of the first surface 11.

Of course, in some embodiments, there may also be no edge region on an edge of a boundary between a portion of the first surface 11 and the side surface 13, for example, in one possible embodiment, in a half cell, after cutting is completed, a cutting surface is formed on the half cell, and the cutting surface is also the side surface 13, in this case, there is no edge region 110 on the boundary edge between the first surface 11 and the cutting surface, but there is the edge region 110 in the vicinity of other boundary edges.

Referring to Fig. 2, in some embodiments, the passivation film layer 40 on the portion of the N-type doped layer 30 located on the edge region 111 has a third thickness D3, the passivation film layer 40 on the portion of the P-type doped layer 20 located on the edge region 111 has a fourth thickness D4, the third thickness D3 is greater than the first thickness D1, and the fourth thickness D4 is greater than the second thickness D2.

In this way, by means of setting the thickness of the passivation film layer on the doped layer on the edge region 111 to be greater, the passivation effect of the edge region 111 can be improved, edge recombination is reduced, and the efficiency of the solar cell 100 is further improved.

Further, in such an embodiment, the third thickness D3 may be greater than the fourth thickness D4. In this way, by means of performing cooperative optimization design of different thicknesses on the passivation film layer 40 on the N-type doped layer 30 and the P-type doped layer 20 in the edge region 111, and setting the thickness of the passivation film layer 40 on the N-type doped layer 30 to be greater, the passivation effect of the edge region 11 can achieve an optimal matching effect.

In some embodiments, the passivation film layer 40 covering the intermediate region 112 is of an integrated continuous structure.

In this way, this portion of passivation film layer 40 can be directly manufactured at one time by a PECVD process, and in the manufacturing process, different thicknesses of different regions can be realized by controlling the conductivity of different regions.

Specifically, herein, the "integrated continuous structure" refers to that the passivation film layer 40 on various portions have the same material and structure, the passivation film layer 40 on the various portions are a whole layer of continuous film layer manufactured by one procedure, but merely have different thicknesses on different regions. Below, if the same description occurs, reference may be made to the understanding herein.

It can be understood that the solar cell 100 further includes metal electrodes, and the metal electrodes penetrate through the passivation film layer 40 to make contact with the doped layer, that is, in a subsequent manufacturing process, when the metal electrodes are manufactured, the passivation film layer 40 at the position corresponding to the metal electrodes may be removed or ablated. Specifically, the back-contact solar cell has P-type electrodes and N-type electrodes (not shown in Figs), the P-type electrode penetrates through the passivation film layer 40 to make contact with the P-type doped layer 20, and the N-type electrode penetrates through the passivation film layer 20 to make contact with an N-type doped layer 13.

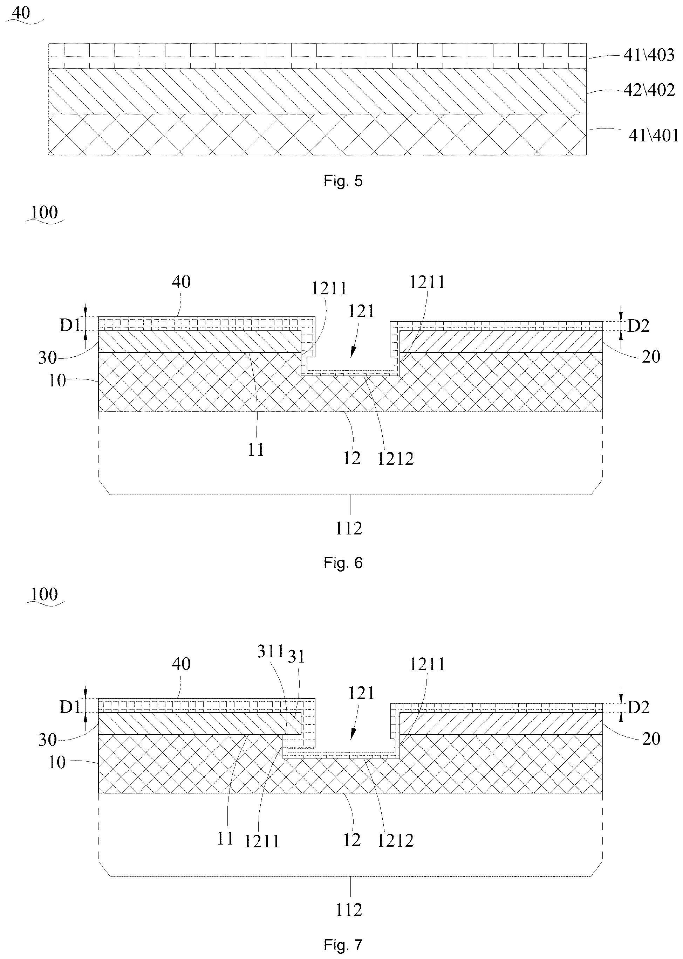

Referring to Fig. 5, in some embodiments, the portion of the passivation film layer 40 located in the intermediate region 112 includes at least one first-type passivation sub-layer 41 and at least one second-type passivation sub-layer 42 that are stacked, and the thickness of the passivation film layer 40 located in the intermediate region 112 is a sum of the thickness of the first-type passivation sub-layer 41 and the thickness of the second-type passivation sub-layer 42; and
the thickness of the portion of the first-type passivation sub-layer 41 located on the N-type doped layer 30 is greater than the thickness of the portion of the first-type passivation sub-layer 41 located on the P-type doped layer 20.

In this way, on one hand, since the passivation film layer 40 on the intermediate region 112 utilizes a structure of different types of passivation sub-layers, the passivation effect can be improved; and on the other hand, by means of setting the thickness of the first-type passivation sub-layer 41 located on the N-type doped layer 30 to be greater than the thickness of the first-type passivation sub-layer 41 located on the P-type doped layer 20, the thickness of the passivation film layer 40 on the intermediate region 112 located on the N-type doped layer 30 is greater than the thickness of the passivation film layer 40 on the intermediate region 112 located on the P-type doped layer 20.

Further, in such an embodiment, the thickness of the portion of the second-type passivation sub-layer 42 located on the N-type doped layer 30 is equal to the thickness of the portion of the second-type passivation sub-layer 42 located on the P-type doped layer 20.

In some embodiments, the first-type passivation sub-layer 41 is manufactured by the PECVD process or a thermal growth process, and the second-type passivation sub-layer 42 is manufactured by an atomic deposition process.

Specifically, in the embodiments of the present disclosure, the first-type passivation sub-layer 41 may include at least one of a silicon oxide film layer, a silicon nitride film layer and a silicon oxynitride film layer, and the second-type passivation sub-layer 42 may include an aluminum oxide film layer, as shown in Fig. 4.

As shown in Fig. 5, in some embodiments, the passivation film layer 40 on the intermediate region 112 may use a three-layer stacked structure of a silicon oxide film layer 401, an aluminum oxide film layer 402 and a silicon nitride film layer 403, the thicknesses of the aluminum oxide film layer 401 on the P-type doped layer 20 and the N-type doped layer 30 may be substantially the same, the thickness of the silicon oxide film layer 401 on the N-type doped layer 30 may be greater than the thickness of the silicon oxide film layer 401 on the P-type doped layer 20, and the thickness of the silicon nitride film layer 403 on the N-type doped layer 30 may be greater than the thickness of the silicon nitride film layer 403 on the P-type doped layer 20.

Of course, in some embodiments, the passivation film layer 40 on the intermediate region 112 may also only use a two-layer stacked structure of the aluminum oxide film layer 402 and the silicon nitride film layer 403, the thicknesses of the aluminum oxide film layer 401 on the P-type doped layer 20 and the N-type doped layer 30 may be substantially the same, and the thickness of the silicon nitride film layer 403 on the N-type doped layer 30 may be greater than the thickness of the silicon nitride film layer 403 on the P-type doped layer 20.

In addition, it should be noted that in some embodiments, the silicon nitride film layer 403 may be of a single-layer film structure or a multi-layer film structure composed of a plurality of silicon nitride layers with different refractive indexes, which is not specifically limited herein.

In addition, in some embodiments, in the solar cell 100, the silicon oxide film layer may be a plurality of layers of silicon oxide stacked in sequence, the silicon nitride film layer may be a plurality of layers of silicon nitride stacked in sequence, and the silicon oxynitride film layer may be a plurality of layers of silicon oxynitride stacked in sequence. That is, in some possible embodiments, the silicon oxide film layer, the silicon nitride film layer and the silicon oxynitride film layer may each be of a multi-layer structure.

In some embodiments, a ratio of the first thickness D1 to the second thickness D2 is greater than 1 and less than or equal to 2, that is, 1<D1/D2≤2.

In this way, since the thickness of the passivation film layer 40 on the N-type doped layer 30 on the intermediate region 112 is relatively large, the passivation effect of the region corresponding to the N-type doped layer 30 can be improved, so that the passivation effects of the regions corresponding to the P-type doped layer 20 and the N-type doped layer 30 achieve a better matching effect, thereby improving the performance of the solar cell 100.

Specifically, in such an embodiment, the ratio of the first thickness D1 to the second thickness D2 may be, for example, 1.01, 1.05, 1.1, 1.15, 1.2, 1.25, 1.3, 1.35, 1.4, 1.45, 1.5, 1.55, 1.6, 1.65, 1.7, 1.75, 1.8, 1.85, 1.9, 1.95, 2, or any numerical value greater than 1 and less than or equal to 2, which is not specifically limited herein.

In some embodiments, the ratio of the first thickness D1 to the second thickness D2 may preferably be 1.025 to 1.6. It is discovered by repeated researches and verification of the inventor of the present disclosure that, by means of setting the ratio of the first thickness D1 to the second thickness D2 within this preferred range, the cost is also relatively low in a case where the passivation effects of the regions corresponding to the P-type doped layer 20 and the N-type doped layer 30 can achieve an optimal matching effect.

Specifically, in such an embodiment, a preferred ratio of the first thickness D1 to the second thickness D2 may be, for example, 1.025, 1.03, 1.04, 1.05, 1.1, 1.15, 1.2, 1.25, 1.3, 1.35, 1.4, 1.45, 1.5, 1.55, 1.6, or any numerical value between 1.025 and 1.6.

In some embodiments, a difference value between the first thickness D1 and the second thickness D2 may be 2 nm to 50 nm. In this way, by means of reasonably designing the difference value between the two thicknesses, the passivation effects of the regions corresponding to the P-type doped layer 20 and the N-type doped layer 30 can achieve a better matching effect, thereby improving the performance of the solar cell 100.

In such an embodiment, the difference value between the first thickness D1 and the second thickness D2 may preferably be 5 nm to 30 nm. It is discovered by repeated researches and verification of the inventor of the present disclosure that, by means of setting the difference value between the first thickness D1 to the second thickness D2 within this preferred range, the cost is also relatively low in a case where the passivation effects of the regions corresponding to the P-type doped layer 20 and the N-type doped layer 30 can achieve an optimal matching effect.

Specifically, in such an embodiment, the difference value between the first thickness D1 and the second thickness D2 may preferably be 5 nm, 7 nm, 9 nm, 10 nm, 12 nm, 14 nm, 16 nm, 18 nm, 20 nm, 22 nm, 24 nm, 26 nm, 28 nm, 30 nm, or any numerical value between 5 nm and 30 nm.

In some embodiments, the first thickness D1 may be 52 nm to 250 nm, and the second thickness D2 may be 50 nm to 200 nm. In this way, by means of setting the first thickness D1 and the second thickness D2 within the above ranges, the passivation film layer 40 can achieve a good passivation effect, and the cost is also relatively low.

In such an embodiment, the first thickness D1 may preferably be 55 nm to 230 nm, and the second thickness D2 may be 50 nm to 200 nm. It is discovered by repeated researches and verification of the inventor of the present disclosure that, by means of setting the magnitudes of the first thickness D1 and the second thickness D2 within this preferred range, the passivation effects of the regions corresponding to the P-type doped layer 20 and the N-type doped layer 30 can achieve an optimal matching effect, and meanwhile, the cost may also be relatively low.

In a preferred embodiment, the first thickness D1 is preferably 55 nm to 230 nm, the second thickness D2 is preferably 50 nm to 200 nm, the difference value between the first thickness D1 and the second thickness D2 is preferably 5 nm to 30 nm, and the ratio of the first thickness D1 to the second thickness D2 is preferably 1.025 to 1.6. In this way, the passivation effects of the regions corresponding to the P-type doped layer 20 and the N-type doped layer 30 can achieve an optimal matching effect, and meanwhile, the cost is also relatively low.

Referring to Fig. 4, in some embodiments, the solar cell 100 is a back-contact solar cell, in this case, there is a spacer region 120 between the P-type doped layer 20 and the N-type doped layer 30 adjacent to each other on the intermediate region 112, the passivation film layer 40 further covers the spacer region 120, and the portion of the passivation film layer 40 located on the spacer region 120 has a fifth thickness D5, where the first thickness D1 is greater than the second thickness D2, and the second thickness D2 is greater than the fifth thickness D5.

In this way, by means of performing reasonable optimal design on the thicknesses of the passivation film layer 40 on the N-type doped layer 30, the P-type doped layer 20 and the spacer region 120 between the N-type doped layer 30 and the P-type doped layer 20 on the intermediate region 112, the passivation effects of the regions corresponding to the three members achieve a good matching effect, and the electrical performance of the solar cell 100 is improved under the condition that the cost is relatively low.

In such an embodiment, on the intermediate region 112, the passivation film layer 40 on the P-type doped layer 20, the passivation film layer 40 on the N-type doped layer 30, and the passivation film layer 40 at the spacer region 120 are of an integrated continuous structure. In this way, the passivation film layer can be directly manufactured at one time via the PECVD process, and different thicknesses of different regions can be achieved by controlling the conductivity of different regions during the manufacturing process.

Further, in some embodiments, a ratio of the second thickness D2 to the fifth thickness D5 may be greater than 1 and less than 2, that is, 1<D2/D5≤2.

In this way, by means of designing the fifth thickness D5, the second thickness D2 and the first thickness D1 in a gradually increase manner and according to the above ratios, the passivation effect of the entire solar cell 100 achieves a better matching effect, thereby improving the performance of the solar cell 100, and meanwhile, the cost is also relatively low.

Specifically, in such an embodiment, the ratio of the second thickness D2 to the fifth thickness D5 may be, for example, 1.01, 1.05, 1.1, 1.15, 1.2, 1.25, 1.3, 1.35, 1.4, 1.45, 1.5, 1.55, 1.6, 1.65, 1.7, 1.75, 1.8, 1.85, 1.9, 1.95, 2, or any numerical value greater than 1 and less than or equal to 2, which is not specifically limited herein.

In some embodiments, in the back-contact solar cell, the ratio of the second thickness D2 to the fifth thickness D5 may preferably be 1.1 to 1.8. It is discovered by repeated researches and verification of the inventor of the present disclosure that, by means of setting the ratio of the second thickness D2 to the fifth thickness D5 within this preferred range, the passivation effects of the regions corresponding to the P-type doped layer 20, the N-type doped layer 30 and the spacer region 120 can achieve an optimal matching effect, and meanwhile, the cost is also relatively low.

Specifically, in such an embodiment, a preferred ratio of the second thickness D2 to the fifth thickness D5 may be, for example, 1.1, 1.15, 1.2, 1.25, 1.3, 1.35, 1.4, 1.45, 1.5, 1.55, 1.6, 1.65, 1.7, 1.75, 1.8, or any numerical value between 1.1 and 1.8.

In some embodiments, a difference value between the second thickness D2 and the fifth thickness D5 may be 2 nm to 50 nm. In this way, by means of reasonably designing the difference value between the two thicknesses, the passivation effects of the regions of the solar cell 100 can achieve a better matching effect, thereby improving the performance of the solar cell 100.

In such an embodiment, the difference value between the second thickness D2 and the fifth thickness D5 may preferably be 20 nm to 40 nm. It is discovered by repeated researches and verification of the inventor of the present disclosure that in the back-contact solar cell, by means of setting the difference value between the second thickness D2 and the fifth thickness D5 within this preferred range, the passivation effects of the regions corresponding to the P-type doped layer 20, the N-type doped layer 30 and the spacer region 120 can achieve an optimal matching effect, thereby improving the performance of the solar cell sheet 100, and meanwhile, the cost is also relatively low.

Specifically, in such an embodiment, the difference value between the second thickness D2 and the fifth thickness D5 may preferably be 20 nm, 22 nm, 24 nm, 26 nm, 28 nm, 30 nm, 32 nm, 34 nm, 36 nm, 38 nm, 40 nm, or any numerical value between 20 nm and 40 nm.

In some embodiments, the second thickness D2 may be 50 nm to 200 nm, and the fifth thickness D5 may be 48 nm to 150 nm. In this way, by means of setting the second thickness D2 and the fifth thickness D5 within the above ranges, the passivation film layer 40 can achieve a good passivation effect, and the cost is relatively low.

In such an embodiment, the second thickness D2 may be 50 nm to 200 nm, and the fifth thickness D5 may preferably be 30 nm to 160 nm. Specifically, It is discovered by repeated researches and verification of the inventor of the present disclosure that, by means of setting the magnitudes of the second thickness D2 and the fifth thickness D5 within this preferred range, the passivation effects of the regions corresponding to the P-type doped layer 20, the N-type doped layer 30 and the spacer region 120 can achieve an optimal matching effect, and meanwhile, the cost is also relatively low.

In a preferred embodiment, the first thickness D1 is preferably 55 nm to 230 nm, the second thickness D2 is preferably 50 nm to 200 nm, the fifth thickness D5 is preferably 30 nm to 160 nm, the difference value between the first thickness D1 and the second thickness D2 is preferably 5 nm to 30 nm, the difference value between the second thickness D2 and the fifth thickness D5 is preferably 20 nm to 40 nm, the ratio of the first thickness D1 to the second thickness D2 is preferably 1.025 to 1.6, and the ratio of the second thickness D2 to the fifth thickness D5 is preferably 1.1 to 1.8. In this way, the passivation effects of the regions corresponding to the P-type doped layer 20, the N-type doped layer 30 and the spacer 120 in the intermediate region 112 can achieve an optimal matching effect, thereby improving the performance of the solar cell 100, and meanwhile, the cost is also relatively low.

In some embodiments, the resistivity of the silicon wafer 10 is greater than 20 ohm.cm, and the difference value between the second thickness D2 and the fifth thickness D5 is 10 nm to 60 nm.

In this way, when the silicon wafer 10 is a high-resistivity silicon wafer 10 with a resistivity greater than 20 ohm.cm, by means of setting the difference value between the second thickness D2 and the fifth thickness D5 within this range, the passivation effect of the region corresponding to the P-type doped layer 20 can reach a better state while the passivation effect of the spacer region 120 is ensured.

Referring to Fig. 6, in some embodiments, the spacer region 120 is a groove 121 formed on the back surface 12 (that is, the groove 121 is formed on the back surface 12 of the silicon wafer 10, and the P-type doped layer 20 and the N-type doped layer 30 are isolated by the groove 121), the passivation film layer 40 covers a side surface 1211 and a bottom surface 1222 of the groove 121, and the thickness of at least some regions of the passivation film layer 40 located on the side surface 1211 of the groove 121 is greater than the thickness of the passivation film layer 40 located on the bottom surface 1212 of the groove 121.

In this way, the passivation matching effect at the groove 121 can be improved, thereby improving the overall passivation performance and improving the performance of the solar cell 100.

Specifically, in such an embodiment, at the doped layers located on both sides of the groove 121, the P-type doped layer 20 usually forms a P-type inner expansion layer (not shown in Figs) in the silicon wafer 10, the N-type doped layer 30 forms an N-type inner expansion layer (not shown in Figs) in the silicon wafer 10, and the P-type inner expansion layer and the N-type inner expansion layer are exposed on the side surface 1211 of the groove 121, so that in order to improve the passivation effect at the groove 121, the thickness of the passivation film layer 40 on the P-type inner expansion layer and the N-type inner expansion layer exposed from the groove 121 may be set to be greater, thereby improving the electrical performance of the solar cell 100.

More specifically, the thickness of the passivation film layer 40 located on the N-type inner expansion layer at the groove 121 may be substantially the same as the first thickness D1 or slightly less than the first thickness D1, and the thickness of the passivation film layer 40 located on the P-type inner expansion layer is substantially the same as the second thickness D2 or slightly less than the second thickness D2.

Referring to Fig. 7, in some embodiments, the N-type doped layer 30 may be provided with a first extension portion 31 extending to the upper side of the groove 121 and suspending above the groove 121, and an end portion of the first extension portion 31 and the surface 311 of the first extension portion 31 facing the groove 121 are both provided with passivation film layer 40, where the thickness of the passivation film layer 40 located on the surface 311 of the first extension portion 31 facing the groove 121 is greater than the thickness of the passivation film layer 40 located on the bottom surface 1212 of the groove 121. In this way, when the N-type doped layer 30 is provided with the first extension portion 31, the passivation effect of the N-type doped layer 30 can be further improved.

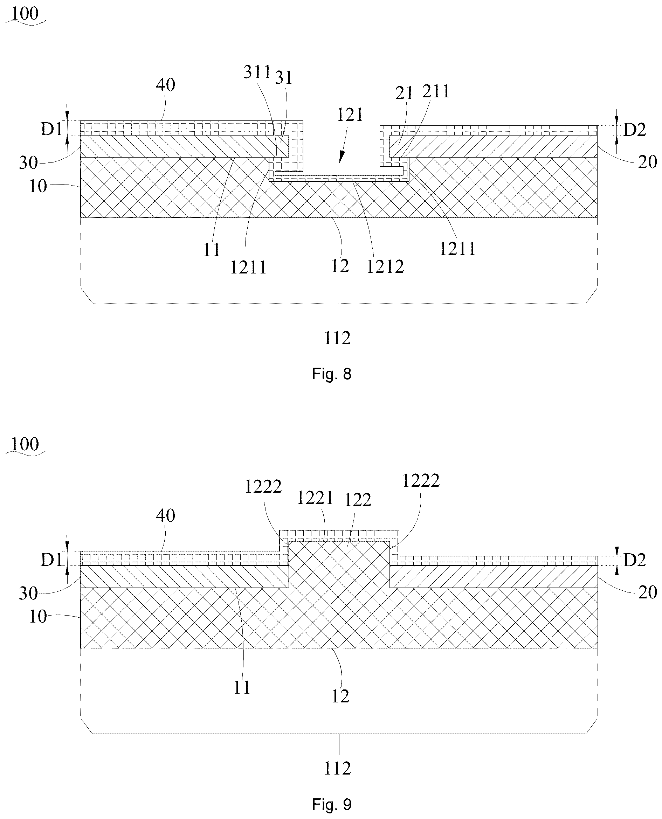

In addition, referring to Fig. 8, in some embodiments, the P-type doped layer 20 may be provided with a second extension portion 21 extending to the upper side of the groove 121 and suspending above the groove 121, and an end portion of the second extension portion 21 and the surface 211 of the second extension portion 21 facing the groove 121 are both provided with passivation film layer 40, where the thickness of the passivation film layer 40 located on the surface 211 of the second extension portion 21 facing the groove 121 is greater than the thickness of the passivation film layer 40 located on the bottom surface 1212 of the groove 121. In this way, when the P-type doped layer 20 is provided with the second extension portion 21, the passivation effect of the P-type doped layer 20 can be further improved.

Referring to Fig. 9, in some embodiments, the spacer region 120 may also be a boss 122 located between the P-type doped layer 20 and the N-type doped layer 30 adjacent to each other, a top surface 1221 of the boss 122 is higher than the top of the P-type doped layer 20 and the top of the N-type doped layer 30, the top surface 1221 and a side surface 1222 of the boss 122 are both provided with passivation film layer 40, and the thickness of the passivation film layer 40 located on the top surface 1221 of the boss 122 is greater than the thickness of the passivation film layer 40 located on the side surface 1222 of the boss 122.

In this way, when doping is performed on the top of the boss 122, by means of setting the thickness of the passivation film layer 40 on the top to be greater, the passivation effect can be improved. It can be understood that the side surface 1222 of the boss 122 refers to a sidewall surface of a protruding portion of the boss 122 protruding from the P-type doped layer 20 and the N-type doped layer 30.

In the description of the present specification, the description with reference to the terms "some embodiments", "an illustrative embodiment", "an example", "a specific example", or "some examples" means that particular features, structures, materials or characteristics described in connection with the embodiment or example are included in at least one embodiment or example of the present disclosure. In the present specification, the schematic representation of the above terms does not necessarily refer to the same embodiment or example. Furthermore, the described particular features, structures, materials or characteristics may be combined in any suitable manner in one or more embodiments or examples.

In addition, the above descriptions are only preferred embodiments of the present disclosure and are not intended to limit the present disclosure, and any modifications, equivalent replacements, improvements and the like, made within the spirit and principles of the present disclosure, should be included in the protection scope of the present disclosure.

## Claims

1. A solar cell, comprising:
a silicon wafer, having a first surface and a second surface opposite to each other;
P-type doped layers and N-type doped layers, disposed on the first surface of the silicon wafer; and
a passivation film layer, disposed on the P-type doped layers and the N-type doped layers, wherein the passivation film layer on at least some regions of the N-type doped layers have a first thickness, the passivation film layer on at least some regions of the P-type doped layers have a second thickness, and the first thickness is greater than the second thickness.

2. The solar cell according to claim 1, wherein the first surface has an edge region and an intermediate region, the intermediate region is located on an inner side of the edge region, and the edge region is closer to an edge of the first surface than the intermediate region; and
a portion of at least one N-type doped layer located on the intermediate region is a first N-type doped portion, the passivation film layer located on the first N-type doped portion has the first thickness, a portion of at least one P-type doped layer located on the intermediate region is a first P-type doped portion, and the passivation film layer located on the first P-type doped portion has the second thickness.

3. The solar cell according to claim 2, wherein a portion of at least one N-type doped layer located on the edge region is a second N-type doped portion, the passivation film layer located on the second N-type doped portion has a third thickness, a portion of at least one P-type doped layer located on the edge region is a second P-type doped portion, the passivation film layer located on the second P-type doped portion has a fourth thickness, the third thickness is greater than the first thickness, and the fourth thickness is greater than the second thickness.

4. The solar cell according to claim 3, wherein the third thickness is greater than the fourth thickness.

5. The solar cell according to claim 2, wherein the passivation film layer covering the intermediate region is of an integrated continuous structure.

6. The solar cell according to any one of claims 1-5, wherein a ratio of the first thickness to the second thickness is greater than 1 and less than or equal to 2.

7. The solar cell according to claim 6, wherein the ratio of the first thickness to the second thickness is 1.025 to 1.6.

8. The solar cell according to any of claims 1-5, wherein a difference value between the first thickness and the second thickness is 2 nm to 50 nm.

9. The solar cell according to claim 8, wherein the difference value between the first thickness and the second thickness is 5 nm to 30 nm.

10. The solar cell according to any of claims 1-5, wherein the first thickness is 52 nm to 250 nm, and the second thickness is 50 nm to 200 nm.

11. The solar cell according to claim 10, wherein the first thickness is 55 nm to 230 nm, and the second thickness is 50 nm to 200 nm.

12. The solar cell according to claim 2, wherein on the intermediate region, there is a spacer region between one P-type doped layer and one N-type doped layer adjacent to each other, the passivation film layer further covers the spacer region, a portion of the passivation film layer located on the spacer region has a fifth thickness, and the second thickness is greater than the fifth thickness.

13. The solar cell according to claim 12, wherein on the intermediate region, the passivation film layer on the P-type doped layers, the passivation film layer on the N-type doped layers, and the passivation film layer on spacer regions is an integrated continuous structure.

14. The solar cell according to claim 12, wherein a ratio of the second thickness to the fifth thickness is greater than 1 and less than or equal to 2.

15. The solar cell according to claim 14, wherein the ratio of the second thickness to the fifth thickness is 1.1 to 1.8.

16. The solar cell according to claim 12, wherein a difference value between the second thickness and the fifth thickness is 2 nm to 50 nm.

17. The solar cell according to claim 16, wherein the difference value between the second thickness and the fifth thickness is 20 nm to 40 nm.

18. The solar cell according to claim 12, wherein the second thickness is 50 nm to 200 nm, and the fifth thickness is 48 nm to 150 nm.

19. The solar cell according to claim 18, wherein the second thickness is 50 nm to 200 nm, and the fifth thickness is 30 nm to 160 nm.

20. The solar cell according to claim 12, wherein a resistivity of the silicon wafer is greater than 20 ohm.cm, and a difference value between the second thickness and the fifth thickness is 10 nm to 60 nm.

21. The solar cell according to claim 12, wherein the spacer region is a groove formed on the first surface, the passivation film layer covers a side surface and a bottom surface of the groove, a thickness of at least some regions of the passivation film layer located on the side surface of the groove is greater than a thickness of the passivation film layer located on the bottom surface of the groove.

22. The solar cell according to claim 21, wherein the solar cell further satisfies at least one of the following:
the N-type doped layer is provided with a first extension portion extending to an upper side of the groove and suspending above the groove, and an end portion of the first extension portion and a surface of the first extension portion facing the groove are both provided with the passivation film layer, wherein a thickness of the passivation film layer located on the surface of the first extension portion facing the groove is greater than the thickness of the passivation film layer located on the bottom surface of the groove; and
the P-type doped layer is provided with a second extension portion extending to the upper side of the groove and suspending above the groove, and an end portion of the second extension portion and a surface of the second extension portion facing the groove are both provided with the passivation film layer, wherein a thickness of the passivation film layer located on the surface of the second extension portion facing the groove is greater than the thickness of the passivation film layer located on the bottom surface of the groove.

23. The solar cell according to claim 12, wherein the spacer region is a boss located between the P-type doped layer and the N-type doped layer adjacent to each other, a top surface of the boss is higher than a top of the P-type doped layer and a top of the N-type doped layer, the top surface and a side surface of the boss are both provided with the passivation film layer, and a thickness of the passivation film layer located on the top surface of the boss is greater than a thickness of the passivation film layer located on the side surface of the boss.

24. The solar cell according to claim 2, wherein a portion of the passivation film layer located on the intermediate region comprises at least one first-type passivation sub-layer and at least one second-type passivation sub-layer that are stacked, and a thickness of the passivation film layer located on the intermediate region is a sum of a thickness of the first-type passivation sub-layer and a thickness of the second-type passivation sub-layer; and
a thickness of a portion of the first-type passivation sub-layer located on the N-type doped layer is greater than a thickness of a portion of the first-type passivation sub-layer located on the P-type doped layer.

25. The solar cell according to claim 24, wherein a thickness of a portion of the second-type passivation sub-layer located on the N-type doped layer is equal to a thickness of a portion of the second-type passivation sub-layer located on the P-type doped layer.

26. The solar cell according to claim 25, wherein the first-type passivation sub-layer is manufactured by a Plasma Enhanced Chemical Vapor Deposition (PECVD) process or a thermal growth process, and the second-type passivation sub-layer is manufactured by an atomic deposition process.

27. The solar cell according to any one of claims 24-26, wherein the first-type passivation sub-layer comprises at least one of a silicon oxide film layer, a silicon nitride film layer and a silicon oxynitride film layer, and the second-type passivation sub-layer comprises an aluminum oxide film layer.

28. The solar cell according to claim 27, wherein the silicon oxide film layer is a plurality of layers of silicon oxide stacked in sequence, the silicon nitride film layer is a plurality of layers of silicon nitride stacked in sequence, and the silicon oxynitride film layer is a plurality of layers of silicon oxynitride stacked in sequence.

29. A cell assembly, comprising the solar cell according to any one of claims 1-28.

30. A photovoltaic system, comprising the cell assembly according to claim 29.
